# EUROPEAN PATENT APPLICATION

(11) **EP 4 421 878 A1**
(43) Date of publication of application: **28.08.2024**
(21) Application number: 23205667.1
(22) Date of filing: 25.10.2023
(51) Int. Cl.: H01L 29/78, H01L 29/06, H01L 29/16, H01L 29/51, H01L 21/336, H01L 29/10

(54) **FIELD-EFFECT TRANSISTORS WITH DEPOSITED GATE DIELECTRIC LAYERS**

(30) Priority: 27.02.2023 US 202318114313
(71) Applicant: GlobalFoundries U.S. Inc., Malta, NY 12020 (US)
(72) Inventor: HEBERT, Francois, Santa Clara, CA, 95054 (US); COOPER, James A., Santa Fe, NM, 87506 (US); MADDI, Hema Lata Rao, Essex Junction, VT, 05452 (US)
(74) Representative: Lambacher, Michael

(57) **Abstract**

Structures for a field-effect transistor and methods of forming a structure for a field-effect transistor. The structure comprises a semiconductor substrate comprising a wide bandgap semiconductor material, a gate electrode, a first gate dielectric layer disposed on the semiconductor substrate, and a second gate dielectric layer disposed between the first gate dielectric layer and the gate electrode.

## Description

### BACKGROUND

The disclosure relates to semiconductor devices and integrated circuit manufacture and, more specifically, to structures for a field-effect transistor and methods of forming a structure for a field-effect transistor.

Wide bandgap semiconductors, such as silicon carbide, may be used in high-power applications and/or high-temperature applications. Silicon carbide is well suited for power switching because of advantageous properties, such as a high saturated drift velocity, a high critical field strength, an exceptional thermal conductivity, and a significant mechanical strength. A metal-oxide-semiconductor field-effect transistor is a type of gate-voltage-controlled power switching device that uses field inversion as a current control mechanism. A metal-oxide-semiconductor field-effect transistor may leverage the favorable properties of a silicon carbide substrate to enable, for example, power converters, motor inverters, and motor drivers that are characterized by high reliability and high efficiency when operating at a high voltage.

The metal-oxide-semiconductor field-effect transistor may include a gate structure having a gate dielectric layer that contains silicon dioxide formed by thermal oxidation process of the silicon carbide substrate. The silicon dioxide may incorporate carbon from the silicon carbide substrate during thermal oxidation, which results in a significant number of interface traps and degradation in the electrical properties of the gate dielectric layer. The interface traps may lower the carrier mobility in an inversion layer formed in the silicon carbide beneath the gate dielectric layer during operation of the metal-oxide-semiconductor field-effect transistor.

Improved structures for a field-effect transistor and methods of forming a structure for a field-effect transistor are needed.

### SUMMARY

In an embodiment of the invention, a structure for a field-effect transistor is provided. The structure comprises a semiconductor substrate comprising a wide bandgap semiconductor material, a gate electrode, a first gate dielectric layer disposed on the semiconductor substrate, and a second gate dielectric layer disposed between the first gate dielectric layer and the gate electrode.

The wide bandgap semiconductor material may comprise silicon carbide.

In addition, the first gate dielectric layer may comprise silicon dioxide, and the second gate dielectric layer may comprise silicon dioxide; alternatively the first gate dielectric layer may comprise aluminum oxide, and the second gate dielectric layer may comprise silicon dioxide.

The second gate dielectric layer may be thicker than the first gate dielectric layer; for instance, the first gate dielectric layer may have a first thickness in a range of 2.5 nanometers to 10 nanometers, the second gate dielectric layer may have a second thickness in a range of 10 nanometers to 50 nanometers, and the second gate dielectric layer may be thicker than the first gate dielectric layer.

According to one variant, the semiconductor substrate may include a trench having a plurality of sidewalls; the gate electrode may be disposed inside the trench, and the first gate dielectric layer and the second gate dielectric layer may be disposed between the gate electrode and the sidewalls of the trench.

According to another variant, the semiconductor substrate may include a top surface, and the first gate dielectric layer and the second gate dielectric layer may be disposed on the top surface of the semiconductor substrate.

According to still another variant, the semiconductor substrate may include a fin having a plurality of sidewalls, and the first gate dielectric layer and the second gate dielectric layer may wrap about the sidewalls of the fin of the semiconductor substrate.

In an embodiment of the invention, a method of forming a structure for a field-effect transistor is provided. The method comprises forming a first gate dielectric layer on a semiconductor substrate, forming a second gate dielectric layer on the first gate dielectric layer, and forming a gate electrode. The semiconductor substrate comprises a wide bandgap semiconductor material, and the second gate dielectric layer is disposed between the gate electrode and the first gate dielectric layer.

The method step of forming the first gate dielectric layer on the semiconductor substrate may comprise depositing the first gate dielectric layer on the semiconductor substrate. The first gate dielectric layer may comprise silicon dioxide or aluminum oxide deposited by atomic layer deposition; the first gate dielectric layer may be deposited at a substrate temperature in a range between 25°C and 400°C.

The method step of forming the second gate dielectric layer on the first gate dielectric layer may comprise depositing a layer comprising silicon on the first gate dielectric layer, and oxidizing the layer with a thermal oxidation process to form the second gate dielectric layer.

According to one implementation, the layer may be deposited at a substrate temperature in a range between 500°C and 650°C, and the layer may be oxidized at a substrate temperature in a range between 550°C and 900°C.

Generally, the second gate dielectric layer may be formed at a higher substrate temperature than the first gate dielectric layer.

Alternatively, the method step of forming the second gate dielectric layer on the first gate dielectric layer may comprise depositing a high temperature oxide by low pressure chemical vapor deposition at a substrate temperature in a range between 400°C and 1000°C.

Alternatively, the method step of forming the second gate dielectric layer on the first gate dielectric layer may comprise depositing silicon dioxide by low pressure chemical vapor deposition or plasma enhanced chemical vapor deposition at a substrate temperature of about 400°C.

Alternatively, the method step of forming the second gate dielectric layer on the first gate dielectric layer may comprise depositing silicon dioxide by chemical vapor deposition using tetraethoxysilane as a reactant.

Independent of the above details, the method may further comprise annealing the first gate dielectric layer and the second gate dielectric layer in an ambient including nitric oxide at a substrate temperature in a range between 1100°C and 1350°C.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIGS. 1-7 are cross-sectional views of a structure at successive fabrication stages of a processing method in accordance with embodiments of the invention.
FIG. 8 is a cross-sectional view of a structure in accordance with alternative embodiments of the invention.
FIG. 9 is a cross-sectional view of a structure in accordance with alternative embodiments of the invention.
FIG. 10 is a cross-sectional view of a structure in accordance with alternative embodiments of the invention.

### DETAILED DESCRIPTION

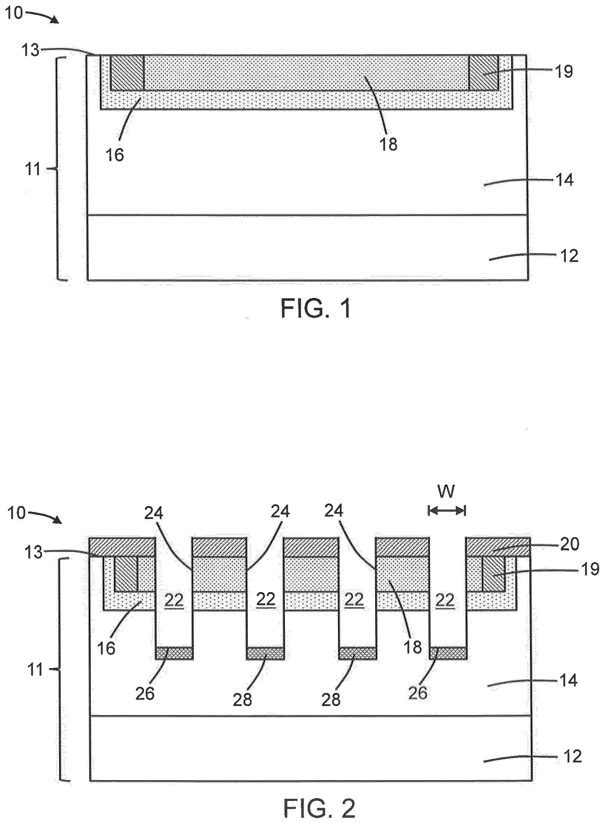

With reference to FIG. 1 and in accordance with embodiments of the invention, a structure 10 for a field-effect transistor may be formed using a semiconductor substrate 11 that includes a bulk substrate 12 and a semiconductor layer 14 formed by, for example, epitaxial growth on the bulk substrate 12. In an embodiment, the semiconductor layer 14 of the semiconductor substrate 11 may be comprised of a wide bandgap semiconductor material. In an embodiment, the bulk substrate 12 of the semiconductor substrate 11 may be comprised of a wide bandgap semiconductor material. In an embodiment, the bulk substrate 12 and the semiconductor layer 14 may be comprised of silicon carbide, which is a wide bandgap semiconductor material. In an embodiment, the bulk substrate 12 and the semiconductor layer 14 may be comprised of diamond, which is a wide bandgap semiconductor material. In an embodiment, the bulk substrate 12 and the semiconductor layer 14 may be comprised of a semiconductor material having a melting point greater than the melting point of silicon. In an embodiment, the bulk substrate 12 and the semiconductor layer 14 may be comprised of silicon carbide that is doped to have n-type electrical conductivity. In an embodiment, the bulk substrate 12 and the semiconductor layer 14 may be comprised of silicon carbide that is doped to have n-type electrical conductivity with the bulk substrate 12 having a higher dopant concentration and a lower electrical resistivity than the semiconductor layer 14. In an embodiment, the bulk substrate 12 may have a resistivity of less than 25 mOhm-cm. In an embodiment, the semiconductor layer 14 may include a buffer layer grown directly on the bulk substrate 12 and a drift region grown on the buffer layer, and the drift region may have a dopant concentration and a thickness that are optimized for device operation in a given voltage range. In an embodiment, the bulk substrate 12 may operate as the drain of the field-effect transistor and may be contacted at the backside of the bulk substrate 12.

A doped region 16 may be formed in the semiconductor layer 14 adjacent to a top surface 13 of the semiconductor substrate 11. The doped region 16 is doped to have an opposite conductivity type from the semiconductor layer 14. The doped region 16 has a lower boundary that defines an interface with the underlying semiconductor material of the semiconductor layer 14 across which the dopant type changes. In an embodiment, the doped region 16 may define a body of the field-effect transistor.

The doped region 16 may be formed by introducing a dopant of a given conductivity type by, for example, ion implantation into the semiconductor layer 14. An implantation mask may be formed to define a selected area on a top surface 13 of the semiconductor substrate 11 that is exposed for the implantation of ions. The implantation mask may include a hardmask that is applied and patterned to form an opening exposing the selected area on the top surface 13 and determining, at least in part, the location and horizontal dimensions of the doped region 16. The implantation conditions (e.g., ion species, dose, kinetic energy, substrate temperature) may be selected to tune the electrical and physical characteristics of the doped region 16, to minimize defects, and to maximize the ionization and activation of the implanted dopants. In an embodiment, the ion implantation may be performed at substrate temperature in a range of 200°C to 600°C to minimize defect formation. The implantation mask, which is compatible with the implantation conditions and is stripped following implantation, has a thickness and stopping power sufficient to block the implantation of ions in masked areas. In an embodiment, the doped region 16 may be doped with a concentration of a p-type dopant (e.g., aluminum) to provide p-type electrical conductivity.

A doped region 19 may be formed in the doped region 16. The doped region 19 may provide a body contact to the body of the field-effect transistor defined by the doped region 16. The doped region 19 may be formed by introducing a dopant of a given conductivity type by, for example, ion implantation into the semiconductor layer 14. An implantation mask may be formed to define a selected area on a top surface 13 of the semiconductor substrate 11 that is exposed for the implantation of ions. The implantation mask may include a hardmask that is applied and patterned to form an opening exposing the selected area on the top surface 13 and determining, at least in part, the location and horizontal dimensions of the doped region 19. The implantation conditions (e.g., ion species, dose, kinetic energy, substrate temperature) may be selected to tune the electrical and physical characteristics of the doped region 19, to minimize defects, and to maximize the ionization and activation of the implanted dopants. In an embodiment, the ion implantation may be performed at substrate temperature in a range of 200°C to 600°C to minimize defect formation. The implantation mask, which is compatible with the implantation conditions and is stripped following implantation, has a thickness and stopping power sufficient to block the implantation of ions in masked areas. In an embodiment, the doped region 19 may be doped with a concentration of a p-type dopant (e.g., aluminum) to provide p-type electrical conductivity, and the dopant concentration of the doped region 19 may be greater than the dopant concentration of the doped region 16. In an alternative embodiment, additional regions similar to the doped region 19 may be disposed within the doped region 16.

A doped region 18 may be formed in the semiconductor layer 14 adjacent to a top surface 13 of the semiconductor substrate 11. The doped region 18 has the same conductivity type as the semiconductor layer 14 but at a higher dopant concentration. The doped region 18 has an upper boundary that may be coplanar or substantially coplanar with the top surface 13 of the semiconductor substrate 11 and a lower boundary that defines an interface with the doped region 16 across which the conductivity type changes. In an embodiment, the doped region 18 may define a source of the field-effect transistor.

The doped region 18 may be formed by introducing a dopant of a given conductivity type by, for example, ion implantation into the semiconductor layer 14. An implantation mask may be formed to define a selected area on a top surface 13 of the semiconductor substrate 11 that is exposed for the implantation of ions. The implantation mask may include a hardmask that is applied and patterned to form an opening exposing the selected area on the top surface 13 of the semiconductor substrate 11 and determining, at least in part, the location and horizontal dimensions of the doped region 18. The implantation conditions (e.g., ion species, dose, kinetic energy, substrate temperature) may be selected to tune the electrical and physical characteristics of the doped region 18. In an embodiment, the ion implantation may be performed at substrate temperature in a range of 200°C to 600°C to minimize defect formation. The implantation mask, which is compatible with the implantation conditions and is stripped following implantation, has a thickness and stopping power sufficient to block the implantation of ions in masked areas. In an embodiment, the doped region 18 may be doped (e.g., heavily doped) with a concentration of an n-type dopant (e.g., nitrogen and/or phosphorus) to provide n-type electrical conductivity. In an embodiment, the doped region 18 may be doped with a higher concentration of the n-type dopant than the semiconductor layer 14.

With reference to FIG. 2 in which like reference numerals refer to like features in FIG. 1 and at a subsequent fabrication stage, a dielectric layer 20 is applied on the top surface 13 of the semiconductor substrate 11 and, in particular, the dielectric layer 20 may be disposed on the top surface 13 over the doped regions 16, 18, 19. The dielectric layer 20 may be comprised of silicon dioxide. Trenches 22, which have a width dimension W, are formed by lithography and etching processes that extend into the semiconductor substrate 11. More specifically, each trench 22 extends from the top surface 13 of the semiconductor substrate 11 through the doped regions 16, 18, 19 and into the semiconductor layer 14 beneath the doped region 16. Each trench 22 has sidewalls 24 and a trench bottom 26 that is positioned between the top surface 13 and the interface between the bulk substrate 12 and the semiconductor layer 14. The dielectric layer 20 may function as a hardmask during the formation of the trenches 22.

A doped region 28 may be formed in the semiconductor layer 14 beneath and adjacent to the trench bottom 26 of each trench 22. The doped regions 28 are positioned in a vertical direction between the trenches 22 and the bulk substrate 12 operating as the drain of the field-effect transistor. The doped regions 28 have an opposite conductivity type from the semiconductor layer 14 and the doped region 16. The doped regions 28, which are formed after forming the trenches 22 and are self-aligned to the trenches 22, may define p-shields of the field-effect transistor and may be connected to the doped region 16.

The doped regions 28 may be formed by introducing a dopant of a given conductivity type by, for example, ion implantation into the semiconductor layer 14. The trenches 22 may determine, at least in part, the location and horizontal dimensions of the doped regions 28. The dielectric layer 20 has a thickness and stopping power sufficient to block the implantation of ions in masked areas. The implantation conditions (e.g., ion species, dose, kinetic energy, substrate temperature, tilt angle) may be selected to tune the electrical and physical characteristics of the doped regions 28. In an embodiment, the ion implantation may be performed at substrate temperature in a range of 200°C to 600°C to minimize defect formation. In an embodiment, the doped regions 28 may be doped with a concentration of a p-type dopant (e.g., aluminum) to provide p-type electrical conductivity.

A high-temperature anneal may be performed following the implantations to activate the implanted dopants and to alleviate post-implantation crystal damage. The high-temperature anneal may be performed with a removable carbon capping layer applied as a temporary coating and at a high temperature, such as a temperature in a range of 1600°C to 1900°C. The dielectric layer 20, which cannot withstand the high anneal temperature, is removed from the top surface 13 before the anneal is performed and before the carbon capping layer is applied. The removable carbon capping layer may prevent silicon outgassing during the high-temperature anneal. The carbon capping layer, which may be comprised of a cured and/or baked photoresist or a deposited layer of carbon, is removed following the high-temperature anneal.

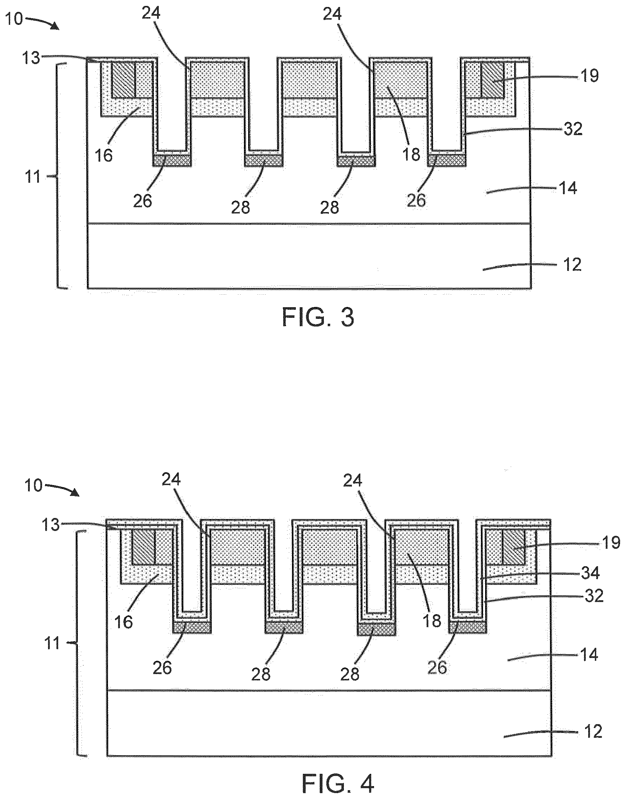

With reference to FIG. 3 in which like reference numerals refer to like features in FIG. 2 and at a subsequent fabrication stage, a gate dielectric layer 32 is deposited on the sidewalls 24 and trench bottom 26 of each trench 22 and on the top surface 13 of the semiconductor substrate 11. In an embodiment, the gate dielectric layer 32 may be conformally deposited with a uniform or substantially uniform thickness on the sidewalls 24 and trench bottom 26. In an embodiment, the gate dielectric layer 32 may be deposited by atomic layer deposition. In an embodiment, the gate dielectric layer 32 may be deposited at a substrate temperature in a range between 25°C and 400°C. In an embodiment, the gate dielectric layer 32 may be comprised of silicon dioxide. In an embodiment, the gate dielectric layer 32 may be comprised of aluminum oxide. In an embodiment, the gate dielectric layer 32 may have a thickness in a range between 2.5 nanometers (nm) and 10 nm.

The semiconductor layer 14 bordering the sidewalls 24 and trench bottoms 26 of the trenches 22, as well as the top surface 13, may be subjected to a cleaning pre-treatment, before depositing the gate dielectric layer 32, that removes a thin surface layer of the semiconductor material. In an embodiment, the cleaning pre-treatment may include a wet chemical cleaning process. In an embodiment, the cleaning pre-treatment may include a plasma etching process. In an embodiment, the cleaning pre-treatment may include a thermal oxidation process to form a thin sacrificial oxide layer followed by a strip of the sacrificial oxide layer. In an embodiment, the cleaning pre-treatment may include a bake in a hydrogen atmosphere at a substrate temperature in the range of 1100°C to 1500°C to etch and remove a thin surface layer of the semiconductor material of the semiconductor layer 14 bordering the trenches 22 and the top surface 13. The hydrogen bake may also function to round the corners of the trenches 22 at the trench bottoms 26. In an embodiment, an isotropic etching process may be employed to provide the surface clean and the corner rounding.

With reference to FIG. 4 in which like reference numerals refer to like features in FIG. 3 and at a subsequent fabrication stage, a gate dielectric layer 34 may be deposited on the gate dielectric layer 32 inside the trenches 22 and on the top surface 13 of the semiconductor substrate 11. The gate dielectric layer 34 is disposed on the sidewalls 24 and trench bottom 26 with the gate dielectric layer 32 between the gate dielectric layer 34 and the surfaces of the semiconductor layer 14 bordering the sidewalls 24 and trench bottom 26. In an embodiment, the gate dielectric layer 34 may be conformally deposited with a uniform or substantially uniform thickness on the sidewalls 24 and trench bottom 26. In an embodiment, the gate dielectric layer 34 may directly contact the gate dielectric layer 32. In an embodiment, the gate dielectric layer 34 may be comprised of silicon dioxide.

In an embodiment, the gate dielectric layer 34 may be a high temperature oxide (HTO) deposited by low pressure chemical vapor deposition at a substrate temperature in a range between 400°C and 1000°C. In an embodiment, the gate dielectric layer 34 may be deposited at a higher substrate temperature than the gate dielectric layer 32. In an embodiment, the gate dielectric layer 34 may be a high temperature oxide (HTO) deposited by low pressure chemical vapor deposition at a substrate temperature of about 800°C and using dichlorosilane and oxygen as reactants. In an alternative embodiment, the gate dielectric layer 34 may be silicon dioxide deposited by chemical vapor deposition using tetraethoxysilane as a reactant. In an alternative embodiment, the gate dielectric layer 34 may be silicon dioxide deposited by low pressure chemical vapor deposition at a substrate temperature of about 400°C and using silane and oxygen as reactants. In an alternative embodiment, the gate dielectric layer 34 may be silicon dioxide deposited by plasma enhanced chemical vapor deposition at a substrate temperature of about 400°C.

In an embodiment, the gate dielectric layer 34 may have a thickness in a range between 10 nm and 50 nm. In an embodiment, the gate dielectric layer 34 may be thicker than the gate dielectric layer 32. In an embodiment, the gate dielectric layer 32 may have a thickness in a range between 2.5 nm and 10 nm, the gate dielectric layer 34 may have a thickness in a range between 10 nm and 50 nm, and the gate dielectric layer 34 may be thicker than the gate dielectric layer 32. The total thickness of the gate dielectric layers 32, 34, which define a conformal liner inside each of the trenches 22, may be contingent upon the gate-source voltage for a given application. In an embodiment, the total thickness of the gate dielectric layers 32, 34 may be in a range between 12.5 nm and 60 nm.

The gate dielectric layers 32, 34 may be annealed to reduce defects, such as interface traps. In an embodiment, the gate dielectric layers 32, 34 may be annealed in an ambient including nitric oxide. In an embodiment, the gate dielectric layers 32, 34 may be annealed in an ambient including nitric oxide at a substrate temperature in a range between 1100°C and 1350°C. In an embodiment, the gate dielectric layers 32, 34 may be annealed in an ambient including only nitrogen. In an embodiment, the gate dielectric layers 32, 34 may be annealed in an ambient including only nitrogen at a substrate temperature in a range between 1250°C and 1400°C. In an embodiment, the gate dielectric layers 32, 34 may be annealed in a forming gas ambient including a mixture of hydrogen and nitrogen. In an embodiment, the gate dielectric layers 32, 34 may be annealed in a forming gas ambient at a substrate temperature in a range between 1000°C and 1400°C. In an alternative embodiment, two or more annealing process may be sequentially preformed, such as an anneal in a nitrogen ambient followed by an anneal in a nitric oxide ambient.

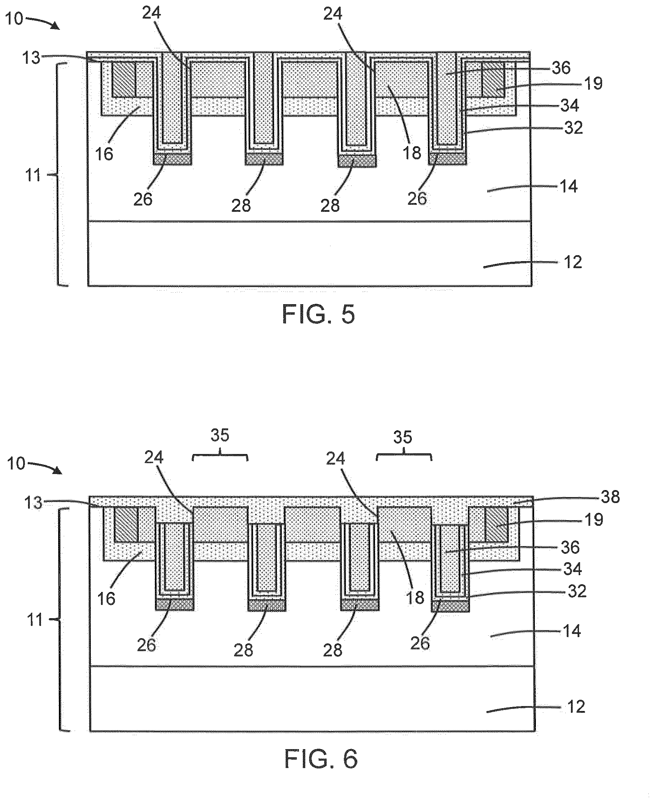

With reference to FIG. 5 in which like reference numerals refer to like features in FIG. 4 and at a subsequent fabrication stage, a gate conductor layer 36 is deposited, and the gate dielectric layers 32, 34 and gate conductor layer 36 may be patterned by lithography and etching processes. In an embodiment, the gate conductor layer 36 may be comprised of a conductor, such as polysilicon or amorphous silicon heavily doped with an n-type dopant (e.g., phosphorus or arsenic). The portion of the gate conductor layer 36 inside each trench 22 defines a gate electrode. Portions of the gate dielectric layers 32, 34 are disposed between the gate electrode and the sidewalls 24 of each trench 22, as well as between the gate electrode and the trench bottom 26 of each trench 22. The gate dielectric layers 32, 34 conform to the shape of the trenches 22 with a substantially uniform or uniform thickness in contrast to gate dielectric material formed by oxidation, which suffers from non-uniform thicknesses, non-uniform interface state densities, and/or non-uniform quality because multiple crystal planes are exposed at the sidewalls 24 and trench bottom 26 of each trench 22 and oxidize at different rates. Forming the gate dielectric layers 32, 34 by deposition eliminates variations in oxide properties arising from formation by oxidation.

With reference to FIG. 6 in which like reference numerals refer to like features in FIG. 5 and at a subsequent fabrication stage, the gate conductor layer 36 is recessed inside each trench 22 by an etching process. A dielectric layer 38 is formed that includes a portion on the portion of the gate conductor layer 36 inside each trench 22. The dielectric layer 38 may be comprised of a dielectric material, such as silicon dioxide, that is an electrical insulator. In an embodiment, the dielectric layer 38 may be formed by oxidizing the material of the gate conductor layer 36 and the material of the semiconductor layer 14 beneath the gate dielectric layers 32, 34 on the top surface 13 with a thermal oxidation process. The gate dielectric layers 32, 34 on the top surface 13 may be subsumed into the dielectric layer 38 and no longer distinguishable. The portions of the dielectric layer 38 on the gate conductor layer 36 are thicker than portions of the dielectric layer 38 formed on the top surface 13. In particular, the portions of the dielectric layers 38 disposed over the gate dielectric layers 32, 34 and the gate conductor layer 36 inside the trenches 22 are thicker than the portions of the dielectric layer 38 disposed on the top surface 13.

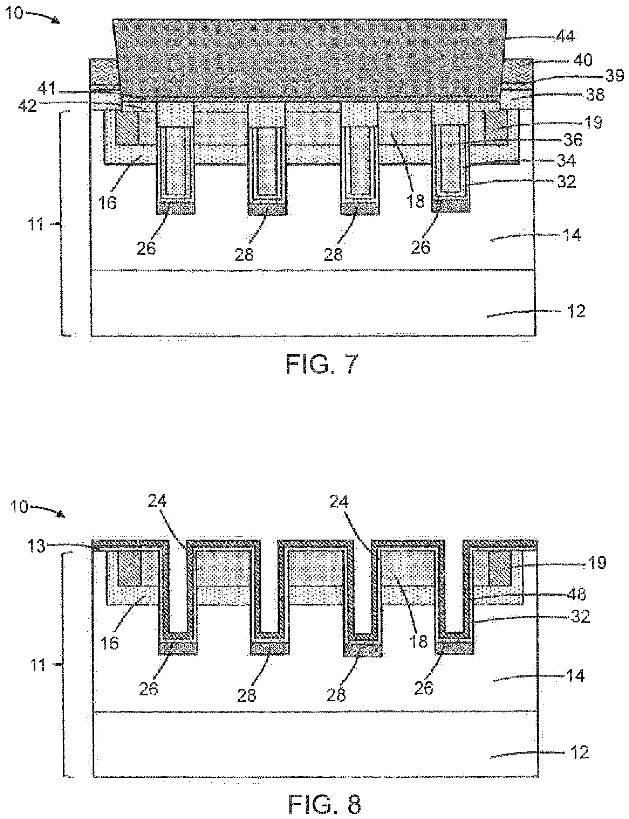

With reference to FIG. 7 in which like reference numerals refer to like features in FIG. 6 and at a subsequent fabrication stage, dielectric layers 39, 40 may be deposited on the top surface 13. Portions of the dielectric layers 39, 40 may fill the divots in the dielectric layer 38. The dielectric layer 39 may be an etch stop layer that is comprised of, for example, silicon nitride, and the dielectric layer 40 may be an interlayer dielectric layer comprised of, for example, silicon dioxide. The dielectric layers 39, 40 are patterned with lithography and etching processes to define an opening extending to the top surface 13.

Silicide layers 42 are formed by a silicidation process on exposed areas of the top surface 13. The silicide layers 42 may be comprised of a metal, such as nickel. An electrode 44 comprised of, for example, aluminum may be formed that is coupled by the silicide layers 42 to the doped region 19 and doped region 18. A barrier layer 41, such as a bilayer of titanium and titanium nitride, may be disposed between the electrode 44 and the silicide layers 42. The dielectric layer 38 inside each trench 22 electrically isolates the electrode 44 from the gate electrodes defined by the gate conductor layers 36 in the trenches 22.

The deposition of multiple gate dielectric layers 32, 34 eliminates the need to thermally grow an oxide layer on the surfaces bordering the trenches 22. The amount of carbon incorporated from the semiconductor layer 14 into the deposited gate dielectric layers 32, 34 may be significantly reduced in comparison with carbon incorporation into silicon dioxide formed by thermal oxidation. For example, the substrate temperature used when deposited in the gate dielectric layer 32 may be significantly lower than the substrate temperature during thermal oxidation. As a result, the gate dielectric layers 32, 34 may include exhibit a lower interface trap number density and a lower interface trap level density in comparison with an oxide layer formed by thermal oxidation, and the carrier mobility in an inversion layer beneath the gate dielectric layers 32, 34, during operation, may be higher due to the reduction in interface traps.

Reliance upon multiple gate dielectric layers 32, 34 permits the gate dielectric layer 32 to be deposited at a lower substrate temperature than the gate dielectric layer 34 to limit carbon incorporation, and then to add the gate dielectric layer 34 at a higher substrate temperature with the silicon dioxide of the gate dielectric layer 32 sealing the wide bandgap semiconductor material. The gate dielectric layer 32 may be thinner than the gate dielectric layer 34, and the gate dielectric layer 32 may have a higher quality than the gate dielectric layer 34. Quality for silicon dioxide may refer to the electrical properties of the silicon carbide-oxide interface and the oxide density. For example, the silicon dioxide of the gate dielectric layer 32 may have a higher density than the silicon dioxide of the gate dielectric layer 34.

With reference to FIG. 8 and in accordance with alternative embodiments, the gate dielectric layer 34 may be formed by depositing a layer 48 on the gate dielectric layer 32 and then oxidizing the layer 48 to form the dielectric material of the gate dielectric layer 34. In an embodiment, the layer 48 may be comprised of silicon deposited by low pressure chemical vapor deposition. In an embodiment, the layer 48 may be comprised of amorphous silicon deposited by low pressure chemical vapor deposition at a relatively low substrate temperature and with a relatively small grain size. In an embodiment, the layer 48 may be comprised of silicon deposited by low pressure chemical vapor deposition at a substrate temperature in a range between 500°C and 650°C to enhance step coverage. In an embodiment, the layer 48 may have a thickness in a range between 10 nm and 40 nm. The layer 48 may be subjected to a thermal oxidation process to form the gate dielectric layer 34 that is arranged on the gate dielectric layer 32. In an embodiment, the thermal oxidation process may be performed at a substrate temperature in a range between 550°C and 900°C and an ambient containing oxygen and optionally hydrogen. The gate dielectric layer 32 may function to self-terminate the oxidation process to ensure that the layer 48 is fully oxidized.

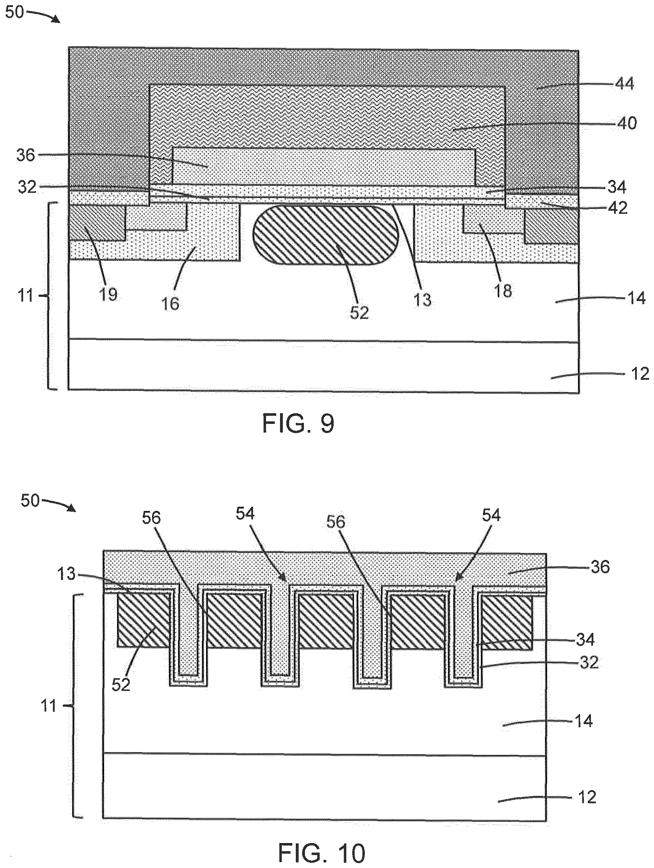

With reference to FIG. 9 and in accordance with alternative embodiments, the gate dielectric layers 32, 34 may be incorporated into a structure 50 for a junction field-effect transistor. The top surface 13 is planar in the absence of gate trenches, and the gate dielectric layers 32, 34 are disposed as planar layers on the planar top surface 13. The structure 50 may include a doped region 52 that is disposed in a portion of the semiconductor layer 14. The doped region 52 may be doped with the same conductivity type as the semiconductor layer 14 but at a higher dopant concentration. The gate conductor layer 36 defines a gate electrode that is disposed on the planar top surface 13.

With reference to FIG. 10 and in accordance with alternative embodiments, the structure 50 incorporating the gate dielectric layers 32, 34 may be a tri-gate junction field-effect transistor that includes a set of fins 54 formed by patterning an upper portion of the semiconductor layer 14. The fins 54 project from an underlying portion of the semiconductor layer 14 and may have sidewalls 56 that extend from the underlying portion of the semiconductor layer 14 to the top surface 13. The gate dielectric layers 32, 34 wrap about the sidewalls 56 of the fins 54 such that the gate dielectric layers 32, 34 conform to the shape of the fins 54.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for a field-effect transistor, the structure comprising:
a semiconductor substrate comprising a wide bandgap semiconductor material;
a gate electrode;
a first gate dielectric layer disposed on the semiconductor substrate; and
a second gate dielectric layer disposed between the first gate dielectric layer and the gate electrode.

2. The structure of claim 1 wherein the wide bandgap semiconductor material comprises silicon carbide.

3. The structure of claim 1 or claim 2 wherein the semiconductor substrate includes a trench having a plurality of sidewalls, the gate electrode is disposed inside the trench, and the first gate dielectric layer and the second gate dielectric layer are disposed between the gate electrode and the sidewalls of the trench.

4. The structure of one of claims 1 to 3 wherein the first gate dielectric layer comprises silicon dioxide, and the second gate dielectric layer comprises silicon dioxide, or wherein the first gate dielectric layer comprises aluminum oxide, and the second gate dielectric layer comprises silicon dioxide.

5. The structure of one of claims 1 to 4 wherein the second gate dielectric layer is thicker than the first gate dielectric layer; or wherein the first gate dielectric layer has a first thickness in a range of 2.5 nanometers to 10 nanometers, the second gate dielectric layer has a second thickness in a range of 10 nanometers to 50 nanometers, and the second gate dielectric layer is thicker than the first gate dielectric layer.

6. The structure of claim 1 or claim 2 wherein the semiconductor substrate includes a top surface, and the first gate dielectric layer and the second gate dielectric layer are disposed on the top surface of the semiconductor substrate.

7. The structure of claim 1 or claim 2 wherein the semiconductor substrate includes a fin having a plurality of sidewalls, and the first gate dielectric layer and the second gate dielectric layer wrap about the sidewalls of the fin of the semiconductor substrate.

8. A method of forming a structure for a field-effect transistor, the method comprising:
forming a first gate dielectric layer on a semiconductor substrate, wherein the semiconductor substrate comprises a wide bandgap semiconductor material;
forming a second gate dielectric layer on the first gate dielectric layer; and
forming a gate electrode, wherein the second gate dielectric layer is disposed between the gate electrode and the first gate dielectric layer.

9. The method of claim 8 wherein forming the first gate dielectric layer on the semiconductor substrate comprises:
depositing the first gate dielectric layer on the semiconductor substrate.

10. The method of claim 9 wherein the first gate dielectric layer comprises silicon dioxide or aluminum oxide deposited by atomic layer deposition, and/or wherein the first gate dielectric layer is deposited at a substrate temperature in a range between 25°C and 400°C.

11. The method of one of claims 8 to 10 wherein forming the second gate dielectric layer on the first gate dielectric layer comprises:
depositing a layer comprising silicon on the first gate dielectric layer; and
oxidizing the layer with a thermal oxidation process to form the second gate dielectric layer, wherein, optionally, the layer is deposited at a substrate temperature in a range between 500°C and 650°C, and the layer is oxidized at a substrate temperature in a range between 550°C and 900°C.

12. The method of one of claims 8 to 11 wherein the second gate dielectric layer is formed at a higher substrate temperature than the first gate dielectric layer.

13. The method of one of claims 8 to 10 wherein forming the second gate dielectric layer on the first gate dielectric layer comprises:
depositing a high temperature oxide by low pressure chemical vapor deposition at a substrate temperature in a range between 400°C and 1000°C; or
depositing silicon dioxide by low pressure chemical vapor deposition or plasma enhanced chemical vapor deposition at a substrate temperature of about 400°C.

14. The method of one of claims 8 to 10 wherein forming the second gate dielectric layer on the first gate dielectric layer comprises:
depositing silicon dioxide by chemical vapor deposition using tetraethoxysilane as a reactant.

15. The method of one of claims 8 to 14 further comprising:
annealing the first gate dielectric layer and the second gate dielectric layer in an ambient including nitric oxide at a substrate temperature in a range between 1 100°C and 1350°C.
